# EUROPEAN PATENT APPLICATION

(11) **EP 4 770 286 A1**
(43) Date of publication of application: **01.07.2026**
(21) Application number: 25226969.1
(22) Date of filing: 23.12.2025
(51) Int. Cl.: H05K 3/18, H05K 3/24, H10W 70/05, H10W 70/60, H05K 1/03, H05K 3/10, H05K 3/40, H05K 3/46, H05K 3/00

(54) **PACKAGING SUBSTRATE AND MANUFACTURE METHOD FOR THE SAME**

(30) Priority: 24.12.2024 US 202463738528 P
(71) Applicant: Absolics Inc., Covington, GA 30014 (US)
(72) Inventor: YOU, YOUNG WOO, Covington, Georgia, 30014 (US)
(74) Representative: BCKIP Part mbB

(57) **Abstract**

A method of manufacturing a packaging substrate according to the present disclosure includes a preparing step of preparing a panel-level packaging substrate comprising a core substrate, a first redistribution layer disposed on the core substrate, and a second redistribution layer disposed under the core substrate, and an electroless surface treatment step of forming terminals by simultaneously performing electroless surface treatment on an upper surface and a lower surface of the panel-level packaging substrate.

The packaging substrate comprises a core layer, the first redistribution layer disposed on the core layer, the second redistribution layer disposed under the core layer, and the terminals disposed on an upper surface of the first redistribution layer and a lower surface of the second redistribution layer. A difference between a maximum thickness value and a minimum thickness value of the terminals formed on the packaging substrate is 5 µm or less.

In such a case, terminals having improved thickness uniformity may be formed, and process efficiency during terminal formation may be promoted.

## Description

This application claims the priority benefit of U.S. Provisional Patent Application No. 63/738,528, filed on December 24, 2024.

### TECHNICAL FIELD

The present disclosure relates to a packaging substrate and a manufacture method for the same.

### BACKGROUND

In manufacturing electronic components, implementing a circuit on a semiconductor wafer is referred to as a front-end (FE: Front-End) process, and assembling the wafer into a state in which it may be used in an actual product is referred to as a back-end (BE: Back-End) process, and a packaging process is included in the back-end process.

Recently, four core technologies of the semiconductor industry that have enabled the rapid development of electronic products are semiconductor technology, semiconductor packaging technology, manufacturing process technology, and software technology. Semiconductor technology is being developed in various forms, such as a line width on the order of nano-units below the micro level, cells of ten million or more, high-speed operation, and a large amount of heat dissipation; however, a technology for perfectly packaging the same has not been supported in a relatively sufficient manner. Accordingly, the electrical performance of a semiconductor may be determined by a packaging technology and an electrical connection according thereto, rather than the performance of the semiconductor technology itself.

As materials for a packaging substrate, ceramic or resin is applied. In the case of a ceramic substrate, it is not easy to mount a high-performance, high-frequency semiconductor device because a resistance value is high or a dielectric constant is high. In the case of a resin substrate, a high-performance, high-frequency semiconductor device may be mounted relatively, but there is a limitation in reducing a pitch of wiring.

Recently, studies of applying silicon or glass as a packaging substrate for high-end use are in progress. A through-hole is formed in a silicon or glass substrate, and a conductive material is applied to the through-hole so that a wiring length between a device and a motherboard becomes short and excellent electrical characteristics may be obtained.

### SUMMARY

A method of manufacturing a packaging substrate according to one embodiment of the present specification comprises:
a preparing step of preparing a panel-level packaging substrate comprising a core substrate, a first redistribution layer disposed on the core substrate, and a second redistribution layer disposed under the core substrate; and
an electroless surface treatment step of manufacturing the packaging substrate by forming terminals by simultaneously performing electroless surface treatment on an upper surface and a lower surface of the panel-level packaging substrate.

The packaging substrate comprises a core layer, the first redistribution layer disposed on the core layer, the second redistribution layer disposed under the core layer, and the terminals disposed on an upper surface of the first redistribution layer and a lower surface of the second redistribution layer.

A difference between a maximum thickness value and a minimum thickness value of the terminals formed on the packaging substrate is 5 µm or less.

The method of manufacturing a packaging substrate may further comprise a singulation step of manufacturing two or more of the packaging substrates by singulating the panel-level packaging substrate after completion of the electroless surface treatment step.

The packaging substrates may respectively and individually have Mt values, which are average thickness values of the terminals.

A difference between a maximum value and a minimum value among the Mt values may be 4 µm or less.

The terminals may comprise a first terminal disposed on the upper surface of the first redistribution layer and a second terminal disposed on the lower surface of the second redistribution layer.

The first terminal may comprise a first nickel layer, a first palladium layer disposed on the first nickel layer, and a first gold layer disposed on the first palladium layer.

The second terminal may comprise a second nickel layer, a second palladium layer disposed under the second nickel layer, and a second gold layer disposed under the second palladium layer.

The first redistribution layer may comprise a first conductive layer in contact with the first terminal.

An average thickness of the first terminal relative to a thickness of the first conductive layer may be in a range of 0.3 to 1.5.

A ratio of an average thickness of the first palladium layer to an average thickness of the first nickel layer may be in a range of 0.01 to 0.05.

A ratio of an average thickness of the second palladium layer to an average thickness of the second nickel layer may be in a range of 0.01 to 0.05.

A ratio of an average thickness of the first gold layer to an average thickness of the first nickel layer may be in a range of 0.01 to 0.05.

A ratio of an average thickness of the second gold layer to an average thickness of the second nickel layer may be in a range of 0.01 to 0.05.

A thickness of the terminals may be in a range of 1 µm to 10 µm.

A packaging substrate according to another embodiment of the present specification comprises a core layer, a first redistribution layer disposed on the core layer, and a second redistribution layer disposed under the core layer.

The packaging substrate further comprises terminals, and the terminals are disposed on the upper surface of the first redistribution layer and the lower surface of the second redistribution layer.

A difference between a maximum thickness value and a minimum thickness value of the terminals is 5 µm or less.

The terminals may comprise a first terminal disposed on the upper surface of the first redistribution layer and a second terminal disposed on the lower surface of the second redistribution layer.

The first terminal may comprise a first nickel layer, a first palladium layer disposed on the first nickel layer, and a first gold layer disposed on the first palladium layer.

The second terminal may comprise a second nickel layer, a second palladium layer disposed under the second nickel layer, and a second gold layer disposed under the second palladium layer.

The first redistribution layer may comprise a first conductive layer in contact with the first terminal.

An average thickness of the first terminal relative to a thickness of the first conductive layer may be in a range of 0.3 to 1.5.

A ratio of an average thickness of the first palladium layer to an average thickness of the first nickel layer may be in a range of 0.01 to 0.05.

A ratio of an average thickness of the second palladium layer to an average thickness of the second nickel layer may be in a range of 0.01 to 0.05.

A ratio of an average thickness of the first gold layer to an average thickness of the first nickel layer may be in a range of 0.01 to 0.05.

A ratio of an average thickness of the second gold layer to an average thickness of the second nickel layer may be in a range of 0.01 to 0.05.

A thickness of the terminals may be in a range of 1 µm to 10 µm.

### BRIEF DESCRIPTION OF THE DRAWINGS

FIG. 1 is a cross-sectional view of a panel-level packaging substrate prepared through a preparing step.
FIG. 2A is a cross-sectional view of a panel-level packaging substrate in which terminals are formed through an electroless surface treatment step.
FIG. 2B is an enlarged view of portion A shown in FIG. 2a.
FIG. 3 is a cross-sectional view of a packaging substrate manufactured through the method of manufacturing a packaging substrate of the present disclosure.

### DETAILED DESCRIPTION

Hereinafter, embodiments will be described in detail with reference to the accompanying drawings so that a person having ordinary skill in the art to which the present invention belongs may easily carry out the present disclosure. However, the present disclosure may be embodied in many different forms and is not limited to the embodiments described herein. Throughout the specification, the same reference numerals are assigned to the same or similar parts.

Throughout the present specification, the term "a combination thereof" included in a Markush-type expression means one or more mixtures or combinations selected from a group consisting of elements described in the Markush-type expression, and means including one or more selected from the group consisting of the elements.

Throughout the present specification, terms such as "first," "second," or "A," "B" are used to distinguish the same terms from each other. In addition, a singular expression includes a plural expression unless otherwise clearly indicated by the context.

In the present specification, the term "-based" may mean a compound corresponding to "-" or compounds including "-" and a derivative of "-".

In the present specification, the meaning that B is positioned on A means that B is positioned directly in contact with A, or that B is positioned on A with another layer interposed therebetween, and is not limited to being interpreted as B being positioned in contact with a surface of A.

In the present specification, the meaning that A is connected to B means that A and B are directly connected or that A and B are connected through another component interposed therebetween, and unless otherwise specified, is not limited to being interpreted as A and B being directly connected.

In the present specification, a singular expression is interpreted to include a singular or plural meaning as interpreted by the context unless otherwise specified.

In the present specification, shapes, relative sizes, angles, and the like of respective components shown in the drawings are illustrated to be exaggerated for the purpose of explanation, and rights are not interpreted as being limited to the drawings.

In the present specification, the meaning that A and B are adjacent to each other means that A and B are positioned in contact with each other, or that A and B are positioned close to each other without being in contact with each other. In the present specification, the expression that A and B are adjacent to each other is not limited to being interpreted as A and B being positioned in contact with each other unless otherwise specified.

Hereinafter, the present disclosure will be described in detail with respect to the present disclosure.

A packaging substrate manufacturing method of the present disclosure manufactures a packaging substrate by including:
a preparing step of preparing a panel-level packaging substrate comprising a core substrate, a first redistribution layer disposed on the core substrate, and a second redistribution layer disposed under the core substrate; and
an electroless surface treatment step of forming terminals by simultaneously performing electroless surface treatment on an upper surface and a lower surface of the panel-level packaging substrate.

### Preparing Step

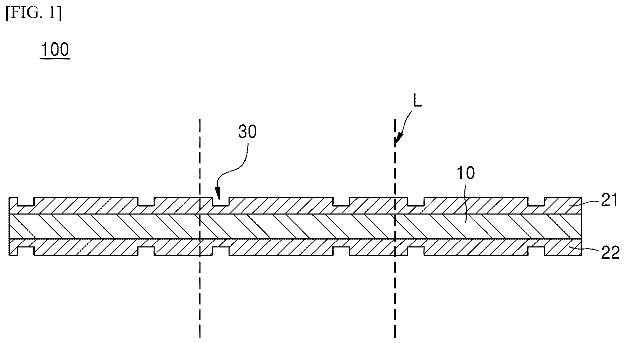

FIG. 1 is a cross-sectional view of a panel-level packaging substrate prepared through the preparing step. Hereinafter, the present disclosure will be described with reference to FIG. 1.

In the preparing step, a panel-level packaging substrate 100 may be prepared. The panel-level packaging substrate 100 is a packaging substrate having a panel size in which respective horizontal and vertical sizes are 500 mm or greater. The panel-level packaging substrate 100 may be singulated to manufacture a packaging substrate.

The panel-level packaging substrate 100 may comprise a core substrate 10. The core substrate 10 is a panel-sized substrate and may function as a support layer. The core substrate 10 is not limited as long as it may be applied in the field of packaging substrates. For example, the core substrate 10 may be an organic substrate, a glass-fiber-impregnated substrate, a ceramic substrate, or a glass substrate.

A thickness of the core substrate 10 may be 100 µm or greater. The thickness may be 200 µm or greater. The thickness may be 300 µm or greater. The thickness may be 3000 µm or less. The thickness may be 2000 µm or less. The thickness may be 1000 µm or less. In this case, the core substrate 10 may have mechanical properties suitable for application to a packaging substrate.

The panel-level packaging substrate 100 may comprise a first redistribution layer 21 disposed on the core substrate 10 and a second redistribution layer 22 disposed under the core substrate 10.

The first redistribution layer 21 and the second redistribution layer 22 may comprise a conductive layer (not shown) and an insulating layer (not shown) surrounding at least a portion of the conductive layer. In the first redistribution layer 21 and the second redistribution layer 22, the conductive layer and the insulating layer may be disposed in a mixed manner. The conductive layer may be disposed to be embedded in the insulating layer.

The conductive layer is a wiring layer that transmits an electrical signal within a packaging substrate. The conductive layer may be formed in a patterned shape. The insulating layer is a layer that imparts insulating properties to a preset region within the first redistribution layer 21 and the second redistribution layer 22. The insulating layer may support and protect the conductive layer.

In the preparing step, a panel-level packaging substrate 100 in which the core substrate 10, the first redistribution layer 21, and the second redistribution layer 22 are already formed may be introduced. In the preparing step, a panel-level packaging substrate 100 may be prepared by forming the first redistribution layer 21 on the core substrate 10 and forming the second redistribution layer 22 under the core substrate 10.

When forming the conductive layer in the first redistribution layer 21 and the second redistribution layer 22, the conductive layer may be formed by a dry method or a wet method.

The dry method is a method in which sputtering is performed on a region of a surface of the core substrate 10 or a surface of the insulating layer on which a conductive layer is to be disposed to form a seed layer, and plating is performed on a region in which the seed layer is formed to form the conductive layer. A seed layer may be formed by sputtering a metal comprising any one selected from the group consisting of titanium, tungsten, tantalum, molybdenum, nickel, chromium, and combinations thereof. After a first seed layer is formed by sputtering the metal, a second seed layer may be formed by sputtering copper on the first seed layer. Through sputtering, an anchor effect in which a surface on which the conductive layer is disposed and deposited metal particles interact with each other occurs, thereby improving adhesion of the conductive layer.

The wet method is a method of forming a seed layer after treating a region where formation of the conductive layer is required with a primer. The primer may comprise a compound having a functional group such as an amine group. Depending on a desired degree of adhesion, the primer may comprise a compound having a functional group such as an amine group and a silane coupling agent together. When a silane coupling agent is applied, a primer layer may be formed by pretreating a target surface to be primer-treated with the silane coupling agent and then coating a compound having an amine group onto the pretreated region.

After the seed layer is formed, the conductive layer may be formed by plating a metal. Copper plating may be applied when forming the conductive layer, but the present disclosure is not limited thereto. Before metal plating, a portion in which formation of the conductive layer is not required within the seed layer or the primer layer may be inactivated, or a portion in which formation of the conductive layer is required may be activated, and then plating may be performed. As an activation or inactivation treatment method, a light irradiation treatment of irradiating a laser having a specific wavelength, a chemical treatment, or the like may be applied. However, after metal plating is performed without applying the activation or inactivation treatment, the conductive layer may be etched and patterned according to a predesigned shape.

The insulating layer may be any insulating layer applicable in the field of packaging substrates. For example, an epoxy-based resin with a filler may be applied to the insulating layer. For example, the insulating layer may be formed using a build-up layer material such as ABF (Ajinomoto Build-up Film) manufactured by Ajinomoto Co., or an undercoat material, but is not limited thereto.

The insulating layer may comprise a filler. The filler is not limited as long as it may be commonly applied in the field of insulating layers. For example, the filler may be silica, alumina, or titania.

The insulating layer may be formed by laminating an uncured or semi-cured insulating film and then curing the film. The insulating layer may be formed by coating a composition for forming an insulating layer and then curing the composition.

The first redistribution layer 21 may further comprise a polyimide layer (not shown) stacked on the insulating layer and the conductive layer. The polyimide layer may impart insulating properties and heat resistance to a desired region in an upper surface of the first redistribution layer 21. Accordingly, it is possible to suppress damage to the insulating layer due to exposure to a high-temperature atmosphere during a manufacturing process of a packaging substrate.

The polyimide layer is not limited as long as it is commonly applied in the field of packaging substrates.

The second redistribution layer 22 may further comprise a solder resist layer (not shown) stacked under the insulating layer and the conductive layer. The solder resist layer may impart insulating properties to a preset region of a lower surface of the second redistribution layer 22 and protect an electrical connection formed in the second redistribution layer 22 from an external force.

The solder resist layer is not limited as long as it is commonly applied in the field of packaging substrates.

The panel-level packaging substrate 100 may comprise terminal disposition regions 30 formed on an upper surface of the first redistribution layer 21 and a lower surface of the second redistribution layer 22. The terminal disposition regions 30 may have a recessed structure. The terminal disposition regions 30 may comprise an empty space in which at least a portion of a terminal may be positioned. In the terminal disposition region 30 formed on the upper surface of the first redistribution layer 21, the polyimide layer may have a through-hole to expose a portion of the conductive layer disposed in the first redistribution layer 21. In the terminal disposition region 30 formed on the lower surface of the second redistribution layer 22, the solder resist layer may have a through-hole to expose a portion of the conductive layer of the second redistribution layer 22.

The terminal disposition regions 30 may be formed by etching regions within the first redistribution layer 21 and the second redistribution layer 22 where the terminal disposition regions 30 are to be disposed. The terminal disposition regions 30 may be formed by laser etching, dry etching, wet etching, or the like. Laser etching may be applied to precisely control a shape of the terminal disposition regions 30.

The panel-level packaging substrate 100 may comprise virtual singulation lines (L). In a singulation step, the panel-level packaging substrate 100 may be divided along the singulation lines (L).

### Electroless Surface Treatment Step

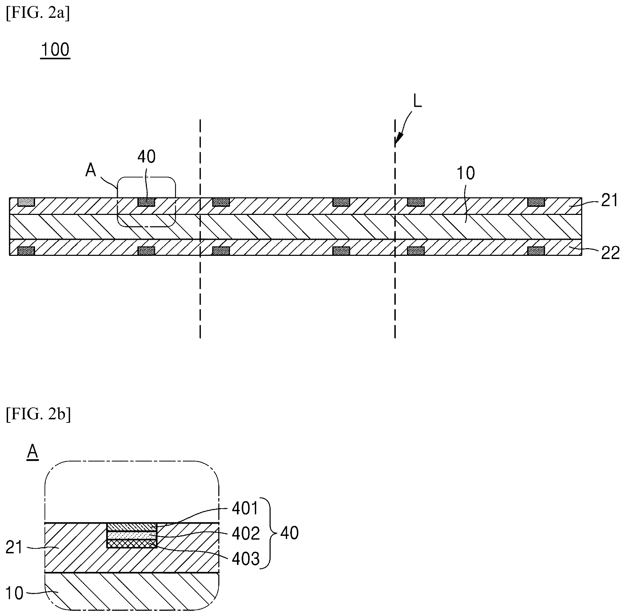

FIG. 2A is a cross-sectional view of a panel-level packaging substrate in which terminals are formed through an electroless surface treatment step, and FIG. 2B is an enlarged view of portion A shown in FIG. 2A. Hereinafter, the present disclosure will be described with reference to FIGS. 2A and 2B.

Descriptions provided above with respect to the core substrate 10, the first redistribution layer 21, the second redistribution layer 22, the singulation line (L), and the like with reference to FIG. 1 are equally applicable. Hereinafter, differences will be mainly described.

The method of manufacturing a packaging substrate of the present disclosure comprises an electroless surface treatment step of forming terminals 40 by simultaneously performing electroless surface treatment on an upper surface and a lower surface of the panel-level packaging substrate 100.

According to the present disclosure, the upper surface and the lower surface of the panel-level packaging substrate 100 may be simultaneously subjected to electroless surface treatment, specifically electroless plating, to form the terminals 40. Accordingly, thickness uniformity of the terminals 40 formed on the upper surface and the lower surface of the packaging substrate may be further improved, and a manufacturing yield of the terminals 40 may be improved. In addition, since the terminals 40 are simultaneously formed on the upper surface and the lower surface of the panel-level packaging substrate 100, the number of processes introduced for forming the terminals 40 may be reduced, thereby promoting process efficiency.

The terminal 40 formed on the upper surface of the first redistribution layer 21 may be a bump. The terminal 40 formed on the lower surface of the second redistribution layer 22 may be a pad.

The electroless surface treatment step may comprise:
a nickel layer forming process of forming a nickel layer 403 by plating the upper surface and the lower surface of the panel-level packaging substrate 100 with an electroless nickel plating solution;
a palladium layer forming process of forming a palladium layer 402 by plating a surface of the nickel layer 403 with an electroless palladium plating solution; and
a gold layer forming process of forming a gold layer 401 by plating a surface of the palladium layer 402 with an electroless gold plating solution.

In the nickel layer forming process, the upper surface of the first redistribution layer 21 and the lower surface of the second redistribution layer 22 may be dipped into a bath containing an electroless nickel plating solution to form the nickel layer 403 in the terminal disposition regions 30. Specifically, in the nickel layer forming process, the nickel layer 403 may be formed on a conductive layer exposed in the terminal disposition regions 30.

In the nickel layer forming process, the electroless nickel plating solution may comprise nickel ions and a reducing agent. The nickel ions may be derived from a nickel salt. Examples of the nickel salt include nickel sulfate, ammonium nickel sulfate, nickel chloride, nickel borofluoride, and nickel sulfamate.

The reducing agent may be any one selected from the group consisting of hypophosphite, hydrazine, sodium borohydride, dimethylamine borane, and combinations thereof.

The electroless nickel plating solution may further comprise an additive as needed. The additive is not limited as long as it is commonly applied in the field of plating. For example, the additive may be a complexing agent, a stabilizer, and/or a modifier.

In the nickel layer forming process, a temperature of the electroless nickel plating solution may be 60° C or higher. The temperature may be 70° C or higher. The temperature may be 100° C or lower. The temperature may be 90° C or lower.

In the nickel layer forming process, a pH of the electroless nickel plating solution may be 3 or higher. The pH may be 4 or higher. The pH may be 7 or lower. The pH may be 6 or lower.

In this case, a deposition rate of metal ions is adjusted, so that a nickel layer 403 having a more uniform thickness may be stably formed.

Through the nickel layer forming process, the nickel layer 403 may be formed in the terminal disposition regions 30 of the upper surface of the first redistribution layer 21 and the lower surface of the second redistribution layer 22. The nickel layer 403 may be electrically connected to the conductive layer in the first redistribution layer 21. The nickel layer 403 may be formed in contact with the conductive layer in the first redistribution layer 21.

The nickel layer 403 may comprise a first nickel layer, which is the nickel layer 403 formed on the upper surface of the first redistribution layer 21, and a second nickel layer, which is the nickel layer 403 formed under the lower surface of the second redistribution layer 22.

An average thickness of the nickel layer 403 may be 1 µm or greater. The average thickness may be 1.5 µm or greater. The average thickness may be 2 µm or greater. The average thickness may be 2.5 µm or greater. The average thickness may be 8 µm or less. The average thickness may be 7.5 µm or less. The average thickness may be 7 µm or less. The average thickness may be 6.5 µm or less. In this case, it may help to form the terminals 40 having stable adhesion to a surface of the redistribution layer.

The present disclosure may form the palladium layer 402 on the nickel layer 403. Accordingly, corrosion of the nickel layer 403 may be suppressed during a process of manufacturing the terminals 40, thereby improving durability of the terminals 40.

In the palladium layer forming process, the upper surface of the first redistribution layer 21 and the lower surface of the second redistribution layer 22 may be dipped into a bath containing an electroless palladium plating solution to form the palladium layer 402 on the nickel layer 403.

In the palladium layer forming process, the electroless palladium plating solution may comprise palladium ions and a reducing agent. The palladium ions may be derived from a palladium salt. Examples of the palladium salt include palladium sulfate and palladium chloride.

The reducing agent may be any one selected from the group consisting of hypophosphite, hydrazine, sodium borohydride, dimethylamine borane, and combinations thereof.

The electroless palladium plating solution may further comprise an additive as needed. The additive is not limited as long as it is commonly applied in the field of plating. Examples of the additive include a complexing agent, a stabilizer, and a pH adjusting agent.

In the palladium layer forming process, a temperature of the electroless palladium plating solution may be 20°C or higher. The temperature may be 30°C or higher. The temperature may be 80°C or lower. The temperature may be 70°C or lower.

In the palladium layer forming process, a pH of the electroless palladium plating solution may be 6 or higher. The pH may be 7 or higher. The pH may be 10 or lower. The pH may be 9 or lower.

In this case, palladium ions are deposited at a controlled rate, so that a palladium layer 402 having a more uniform thickness distribution may be formed.

Through the palladium layer forming process, the palladium layer 402 may be formed on an upper surface of the first nickel layer and on a lower surface of the second nickel layer. The palladium layer 402 may comprise a first palladium layer formed on the first nickel layer and a second palladium layer formed under the second nickel layer. The first palladium layer may be formed in contact with the upper surface of the first nickel layer. The second palladium layer may be formed in contact with the lower surface of the second nickel layer.

An average thickness of the palladium layer 402 may be 0.01 µm or greater. The average thickness may be 0.03 µm or greater. The average thickness may be 0.05 µm or greater. The average thickness may be 1 µm or less. The average thickness may be 0.8 µm or less. The average thickness may be 0.5 µm or less. The average thickness may be 0.3 µm or less. In this case, it may help suppress damage to the nickel layer 403 during a process of forming a gold layer 401 to be described below, and help form the terminals 40 with a more uniform thickness distribution.

In the gold layer forming process, the upper surface of the first redistribution layer 21 and the lower surface of the second redistribution layer 22 may be dipped into a bath containing an electroless gold plating solution to form the gold layer 401 on the palladium layer 402.

In the gold layer forming process, the electroless gold plating solution may comprise gold ions. The electroless gold plating solution may further comprise an additive as needed. The additive is not limited as long as it is commonly applied in the field of plating. Examples of the additive include a complexing agent.

In the gold layer forming process, a temperature of the electroless gold plating solution may be 60° C or higher. The temperature may be 70° C or higher. The temperature may be 100° C or lower. The temperature may be 90° C or lower.

In the gold layer forming process, a pH of the electroless gold plating solution may be 3 or higher. The pH may be 4 or higher. The pH may be 10 or lower. The pH may be 9 or lower.

In this case, the gold layer 401 may be stably stacked on the palladium layer 402.

Through the gold layer forming process, the gold layer 401 may be formed on an upper side of the first redistribution layer 21 and on a lower side of the second redistribution layer 22. The gold layer 401 may comprise a first gold layer formed on the first palladium layer and a second gold layer formed under the second palladium layer. The first gold layer may be formed in contact with the first palladium layer. The second gold layer may be formed in contact with the second palladium layer.

An average thickness of the gold layer 401 may be 0.01 µm or greater. The average thickness may be 0.03 µm or greater. The average thickness may be 0.05 µm or greater. The average thickness may be 1 µm or less. The average thickness may be 0.8 µm or less. The average thickness may be 0.5 µm or less. The average thickness may be 0.3 µm or less. In this case, terminals 40 having excellent oxidation resistance may be formed.

The first redistribution layer 21 may comprise a conductive layer. The conductive layer may comprise a first conductive layer contacting the first terminal. The first conductive layer may be a conductive layer disposed at an uppermost position within the first redistribution layer 21.

An average thickness of the first terminal relative to a thickness of the first conductive layer may be in a range of 0.3 to 1.5. The ratio may be 0.4 or greater. The ratio may be 0.5 or greater. The ratio may be 1.3 or less. The ratio may be 1.1 or less.

An average thickness of the second terminal relative to a thickness of a second conductive layer may be in a range of 0.3 to 1.5. The ratio may be 0.4 or greater. The ratio may be 0.5 or greater. The ratio may be 1.3 or less. The ratio may be 1.1 or less.

In this case, it may help to form a stable electrical connection between the packaging substrate and a device.

A ratio of an average thickness of the first palladium layer to an average thickness of the first nickel layer may be in a range of 0.01 to 0.05. The ratio may be 0.012 or greater. The ratio may be 0.014 or greater. The ratio may be 0.017 or greater. The ratio may be 0.04 or less.

A ratio of an average thickness of the second palladium layer to an average thickness of the second nickel layer may be in a range of 0.01 to 0.05. The ratio may be 0.012 or greater. The ratio may be 0.014 or greater. The ratio may be 0.017 or greater. The ratio may be 0.04 or less.

When thickness ratios of the respective layers are controlled as described above, deterioration in durability of the terminals 40 due to corrosion may be effectively suppressed.

A ratio of an average thickness of the first gold layer to an average thickness of the first nickel layer may be in a range of 0.01 to 0.05. The ratio may be 0.012 or greater. The ratio may be 0.014 or greater. The ratio may be 0.017 or greater. The ratio may be 0.04 or less.

A ratio of an average thickness of the second gold layer to an average thickness of the second nickel layer may be in a range of 0.01 to 0.05. The ratio may be 0.012 or greater. The ratio may be 0.014 or greater. The ratio may be 0.017 or greater. The ratio may be 0.04 or less.

When the terminals are formed to have the above ratios, excessive degradation of the terminals 40 due to oxidation may be suppressed.

### Singulation Step

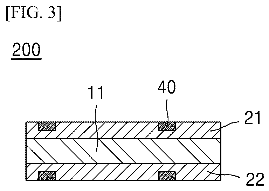

FIG. 3 is a cross-sectional view of a packaging substrate manufactured through The method of manufacturing a packaging substrate of the present disclosure. Hereinafter, the present disclosure will be described with reference to FIG. 3.

Descriptions provided above with respect to the first redistribution layer 21, the second redistribution layer 22, and the like with reference to FIGS. 1, 2A, and 2B are equally applicable. Hereinafter, differences will be mainly described.

The method of manufacturing a packaging substrate of the present disclosure may further comprise a singulation step of manufacturing two or more packaging substrates 200 by singulating the panel-level packaging substrate after completion of the electroless surface treatment step.

In the singulation step, the panel-level packaging substrate may be singulated by a known singulation method to manufacture the packaging substrates 200.

When the core substrate is a glass substrate, the singulation step may be performed as follows. In the singulation step, the first redistribution layer 21 and the second redistribution layer 22 within the panel-level packaging substrate positioned on a singulation line may be removed. By removing the redistribution layers, a groove may be formed in the exposed core substrate, and an external force may be applied to the panel-level packaging substrate so that the packaging substrate 200 may be divided along the singulation line.

As necessary, an edge of the packaging substrate 200 formed through the singulation step may be grinded to smoothly process a side surface of the core layer 11 in the packaging substrate 200, or to make the side surface having a chamfered shape.

The packaging substrate 200 may comprise a core layer 11, a first redistribution layer 21 disposed on the core layer 11, and a second redistribution layer 22 disposed under the core layer 11.

The core layer 11 may be a layer derived from the core substrate. The core layer 11 may be formed by dividing the core substrate in the singulation step. That is, the core layer 11 may be the same as the core substrate in terms of an applied material and a thickness.

Descriptions of the first redistribution layer 21 and the second redistribution layer 22 are omitted because they overlap with those described above.

According to the present disclosure, a packaging substrate 200 in which a thickness distribution characteristic of the terminals 40 is controlled may be provided. Accordingly, a yield of formed terminals 40 may be improved, and it may help to form smooth electrical signals between a device mounted on the packaging substrate 200 and a main board on which the packaging substrate 200 is mounted.

A thickness of the terminals 40 may be measured using a three-dimensional thickness measuring device.

A difference between a maximum thickness value and a minimum thickness value of the terminals 40 formed on the packaging substrate 200 may be 5 µm or less. The difference may be 4 µm or less. The difference may be 3 µm or less. The difference may be 2 µm or less. The difference may be 0.1 µm or greater. In this case, degradation in electrical reliability of the packaging substrate 200 due to defects in the terminals 40 may be effectively suppressed.

The difference is a value measured within a single packaging substrate 200.

The packaging substrates 200 formed through the singulation step may respectively and individually have Mt values, which are average thickness values of the terminals 40. The Mt value means an average thickness value of the terminals 40 formed on one packaging substrate 200.

A difference between a maximum value and a minimum value among the Mt values may be 4 µm or less. The difference may be 3.5 µm or less. The difference may be 3 µm or less. The difference may be 0.1 µm or greater. In this case, excessive variation in thickness distribution of the terminals 40 in the packaging substrate 200 depending on a position within the panel-level packaging substrate may be prevented.

When calculating the difference between the maximum value and the minimum value among the Mt values, the Mt values are measured from packaging substrates formed by dividing one panel-level packaging substrate.

A thickness of the terminals 40 may be in a range of 1 µm to 10 µm. The thickness may be 1.5 µm or greater. The thickness may be 2 µm or greater. The thickness may be 2.5 µm or greater. The thickness may be 8 µm or less. In this case, it may help provide terminals 40 having excellent long-term durability and electrical reliability.

### Packaging Substrate

A packaging substrate 200 of the present disclosure comprises a core layer 11, a first redistribution layer 21 disposed on the core layer 11, and a second redistribution layer 22 disposed under the core layer 11. The core layer 11, the first redistribution layer 21, and the second redistribution layer 22 may respectively have the same configurations as those described above with respect to the core layer 11, the first redistribution layer 21 and the second redistribution layer 22. Descriptions of the core layer 11, the first redistribution layer 21, and the second redistribution layer 22 are omitted because they overlap with those described above.

The packaging substrate 200 may further comprise terminals 40. The terminals 40 may be disposed on an upper surface of the first redistribution layer 21. The terminals 40 may comprise first terminals disposed on the upper surface of the first redistribution layer 21. The terminals 40 may be disposed on a lower surface of the second redistribution layer 22. The terminals 40 may comprise second terminals disposed on the lower surface of the second redistribution layer 22. The terminals 40 described above may be applied as the terminals 40. Descriptions of the terminals 40 are omitted because they overlap with those described above.

The first terminal may comprise a first nickel layer, a first palladium layer disposed on the first nickel layer, and a first gold layer disposed on the first palladium layer. The second terminal may comprise a second nickel layer, a second palladium layer disposed under the second nickel layer, and a second gold layer disposed under the second palladium layer.

A thickness of the first nickel layer may be 1 µm or greater. The thickness may be 1.5 µm or greater. The thickness may be 2 µm or greater. The thickness may be 2.5 µm or greater. The thickness may be 8 µm or less. The thickness may be 7.5 µm or less. The thickness may be 7 µm or less. The thickness may be 6.5 µm or less.

A thickness of the second nickel layer may be 1 µm or greater. The thickness may be 1.5 µm or greater. The thickness may be 2 µm or greater. The thickness may be 2.5 µm or greater. The thickness may be 8 µm or less. The thickness may be 7.5 µm or less. The thickness may be 7 µm or less. The thickness may be 6.5 µm or less.

In this case, it may be possible to provide the terminals 40 having excellent durability and electrical connectivity on a surface of the redistribution layer.

A thickness of the first palladium layer may be 0.01 µm or greater. The thickness may be 0.03 µm or greater. The thickness may be 0.05 µm or greater. The thickness may be 1 µm or less. The thickness may be 0.8 µm or less. The thickness may be 0.5 µm or less. The thickness may be 0.3 µm or less.

A thickness of the second palladium layer may be 0.01 µm or greater. The thickness may be 0.03 µm or greater. The thickness may be 0.05 µm or greater. The thickness may be 1 µm or less. The thickness may be 0.8 µm or less. The thickness may be 0.5 µm or less. The thickness may be 0.3 µm or less.

In this case, damage to the nickel layer during formation of the terminals 40 may be effectively suppressed so that formation of a black pad may be suppressed, and it may contribute to improving thickness uniformity of the terminals 40.

A thickness of the first gold layer may be 0.01 µm or greater. The thickness may be 0.03 µm or greater. The thickness may be 0.05 µm or greater. The thickness may be 1 µm or less. The thickness may be 0.8 µm or less. The thickness may be 0.5 µm or less. The thickness may be 0.3 µm or less.

A thickness of the second gold layer may be 0.01 µm or greater. The thickness may be 0.03 µm or greater. The thickness may be 0.05 µm or greater. The thickness may be 1 µm or less. The thickness may be 0.8 µm or less. The thickness may be 0.5 µm or less. The thickness may be 0.3 µm or less.

In this case, degradation due to surface oxidation of the terminals 40 may be effectively suppressed.

The first redistribution layer 21 may comprise a first conductive layer contacting the first terminal. The first conductive layer may be a conductive layer disposed at an uppermost position within the first redistribution layer 21.

A thickness of the first terminal relative to a thickness of the first conductive layer may be in a range of 0.3 to 1.5. The ratio may be 0.4 or greater. The ratio may be 0.5 or greater. The ratio may be 1.3 or less. The ratio may be 1 or less.

The terminals 40 having such characteristics may provide a stable electrical connection between the packaging substrate 200 and an external component.

A ratio of a thickness of the first palladium layer to a thickness of the first nickel layer may be in a range of 0.01 to 0.05. The ratio may be 0.012 or greater. The ratio may be 0.014 or greater. The ratio may be 0.017 or greater. The ratio may be 0.04 or less.

A ratio of a thickness of the second palladium layer to a thickness of the second nickel layer may be in a range of 0.01 to 0.05. The ratio may be 0.012 or greater. The ratio may be 0.014 or greater. The ratio may be 0.017 or greater. The ratio may be 0.04 or less.

In this case, formation of black pads may be suppressed, and the terminals 40 having excellent thickness uniformity and durability may be provided.

A ratio of a thickness of the first gold layer to a thickness of the first nickel layer may be in a range of 0.01 to 0.05. The ratio may be 0.012 or greater. The ratio may be 0.014 or greater. The ratio may be 0.017 or greater. The ratio may be 0.04 or less.

A ratio of a thickness of the second gold layer to a thickness of the second nickel layer may be in a range of 0.01 to 0.05. The ratio may be 0.012 or greater. The ratio may be 0.014 or greater. The ratio may be 0.017 or greater. The ratio may be 0.04 or less.

In this case, damage to the terminals 40 due to oxidation may be stably suppressed.

The packaging substrate 200 of the present disclosure may have a thickness distribution within a range preset in the present disclosure, and may exhibit excellent electrical connection characteristics over an entire region.

In the packaging substrate 200, a difference between a maximum thickness value and a minimum thickness value of the terminals 40 may be 5 µm or less. The difference may be 4 µm or less. The difference may be 3 µm or less. The difference may be 0.1 µm or greater. In this case, the packaging substrate 200 may exhibit excellent electrical connectivity overall.

Descriptions of a thickness measurement method for the terminals 40 are omitted because they overlap with those described above.

Hereinafter, the present disclosure will be described in more detail through specific examples. The following examples are merely examples for helping understanding of the present disclosure, and the scope of the present disclosure is not limited thereto.

### Manufacturing Example: Formation of Packaging Substrate

**Example 1:** A patterned conductive layer was formed on a glass substrate having a width of 510 mm and a length of 515 mm, a build-up film was laminated on the conductive layer, and then cured to form an insulating layer. After a patterned conductive layer was again formed on the insulating layer, a polyimide film having a thickness of 5 µm was laminated on the conductive layer to complete a first redistribution layer.

A patterned conductive layer was formed under the glass substrate, a build-up film was laminated under the conductive layer, and then cured to form an insulating layer. After a patterned conductive layer was again formed under the insulating layer, a solder resist film having a thickness of 25 µm was formed under the conductive layer to complete a second redistribution layer, thereby preparing a panel-level packaging substrate.

A thickness of a conductive layer disposed at an uppermost position in the first redistribution layer was applied as 5 µm.

Terminal formation regions were formed by forming 185,000 via holes each having a diameter of 10 µm in an upper polyimide film and by forming 3,469 through-holes each having a diameter of 500 µm in a lower solder resist film, thereby exposing surfaces of portions of the conductive layer.

The upper surface and the lower surface of the panel-level packaging substrate in which the terminal formation regions were formed were immersed in an electroless nickel plating solution having a pH of 4.5 and a temperature of 80° C for 25 minutes, thereby forming a first nickel layer on the conductive layer in the first redistribution layer and forming a second nickel layer under the conductive layer in the second redistribution layer. An average thickness target of the first nickel layer and the second nickel layer was applied as 3 µm.

The upper surface and the lower surface of the panel-level packaging substrate after completion of forming the nickel layers were immersed in an electroless palladium plating solution having a pH of 7.5 and a temperature of 46° C for 7 minutes, thereby forming a first palladium layer on the first nickel layer and forming a second palladium layer under the second nickel layer. An average thickness target of the first palladium layer and the second palladium layer was applied as 0.1 µm.

The upper surface and the lower surface of the panel-level packaging substrate after completion of forming the palladium layers were immersed in an electroless gold plating solution having a pH of 7.1 and a temperature of 82° C for 12 minutes, thereby forming a first gold layer on the first palladium layer and forming a second gold layer under the second palladium layer. An average thickness target of the first gold layer and the second gold layer was applied as 0.1 µm.

The panel-level packaging substrate after completion of forming the gold layers was singulated to complete a packaging substrate.

**Example 2:** A packaging substrate was prepared under the same conditions as in Example 1, except that an average thickness target of the first nickel layer and the second nickel layer was applied as 4 µm, and average thickness targets of the first palladium layer, the second palladium layer, the first gold layer, and the second gold layer were respectively applied as 0.07 µm.

**Example 3:** A packaging substrate was prepared under the same conditions as in Example 1, except that a thickness of the conductive layer was applied as 4 µm, an average thickness target of the first nickel layer and the second nickel layer was applied as 4 µm, and average thickness targets of the first palladium layer, the second palladium layer, the first gold layer, and the second gold layer were respectively applied as 0.07 µm.

**Comparative Example 1:** A packaging substrate was prepared under the same conditions as in Example 1, except that the first nickel layer and the first gold layer were formed by an electrolytic plating method, average thickness targets of the first nickel layer and the second nickel layer were applied as 2 µm, average thickness targets of the first gold layer and the second gold layer were respectively applied as 0.08 µm, and the first palladium layer and the second palladium layer were not formed. When forming the first nickel layer and the second nickel layer, conditions of pH 4, a plating solution temperature of 50° C, and a plating time of 6 minutes were applied, and when forming the first gold layer and the second gold layer, conditions of pH 7.5, a plating solution temperature of 55° C, and a plating time of 3 minutes were applied.

**Comparative Example 2:** A packaging substrate was prepared under the same conditions as in Comparative Example 1, except that average thickness targets of the first nickel layer and the second nickel layer were applied as 4 µm, and average thickness targets of the first gold layer and the second gold layer were respectively applied as 0.07 µm.

**Comparative Example 3:** A packaging substrate was prepared under the same conditions as in Comparative Example 1, except that a thickness of the conductive layer was applied as 4 µm, average thickness targets of the first nickel layer and the second nickel layer were applied as 4 µm, and average thickness targets of the first gold layer and the second gold layer were respectively applied as 0.07 µm.

Process conditions of Examples and Comparative Examples are shown in Table 1 below.

### Evaluation Example: Evaluation of Terminal Thickness Distribution Characteristics Within a Single Packaging Substrate

Terminal thicknesses formed on packaging substrates of Examples and Comparative Examples were measured by a 3D thickness measuring instrument. A value obtained by subtracting a minimum value from a maximum value among the measured thickness values was calculated.

Measured values of Examples and Comparative Examples are shown in Table 2 below.

### Evaluation Example: Evaluation of Terminal Thickness Distribution Characteristics of Packaging Substrates Derived from a Single Panel-Level Packaging Substrate

Mt values, which are average thickness values of terminals of packaging substrates derived from one panel-level packaging substrate, were individually measured for Examples and Comparative Examples. A value obtained by subtracting a minimum value from a maximum value among the measured Mt values was calculated and is shown in Table 2 below.

**[Table 1]**

| | Thickness of Conductive Layer (µm) | Average Thickness of First and Second Nickel Layers (µm) | Average Thickness of First and Second Palladium Layers (µm) | Average Thickness of First and Second Gold Layers (µm) | Ratio of Thickness of First Terminal to Thickness of First Conductive Layer | Ratio of Average Thickness of First Palladium Layer to Average Thickness of First Nickel Laver | Ratio of Average Thickness of First Gold Layer to Average Thickness of First Nickel Layer |
|---|---|---|---|---|---|---|---|
| Example 1 | 5 | 3 | 0.1 | 0.1 | 0.64 | 0.03 | 0.03 |
| Example 2 | 5 | 4 | 0.07 | 0.07 | 0.83 | 0.02 | 0.02 |
| Example 3 | 4 | 4 | 0.07 | 0.07 | 1.04 | 0.02 | 0.02 |
| Comparative Example 1 | 5 | 3 | - | 0.1 | 0.62 | - | 0.03 |
| Comparative Example 2 | 5 | 4 | - | 0.07 | 0.81 | - | 0.02 |
| Comparative Example 3 | 4 | 4 | - | 0.07 | 1.02 | - | 0.02 |

**[Table 2]**

| | Difference Between Maximum Thickness Value and Minimum Thickness Value of Terminals Within One Packaging Substrate (µm) | Difference Between Maximum Mt Value and Minimum Mt Value (µm) |
|---|---|---|
| Example 1 | 2 | 2.2 |
| Example 2 | 1.9 | 1.7 |
| Example 3 | 1.7 | 1.6 |
| Comparative Example 1 | 5.2 | 4.1 |
| Comparative Example 2 | 5.8 | 4.6 |
| Comparative Example 3 | 5.6 | 4.5 |

From Table 2 above, with respect to a difference between the maximum thickness value and the minimum thickness value of terminals within one packaging substrate, Examples 1 to 3 were measured to be 2 µm or less, whereas Comparative Examples 1 to 3 were measured to exceed 5 µm.

With respect to a difference between the maximum Mt value and the minimum Mt value, Examples 1 to 3 were measured to be 2.5 µm or less, whereas Comparative Examples 1 to 3 were measured to exceed 4 µm.

As described above, preferred embodiments of the present disclosure have been described in detail. However, the scope of rights of the present disclosure is not limited thereto, and various modifications and improvements by a person having ordinary skill in the art using the basic concept of the present disclosure defined in the following claims also belong to the scope of rights of the present disclosure.

### [Description of Reference Numerals]

100: panel-level packaging substrate
10: core substrate
11: core layer
21: first redistribution layer 22: second redistribution layer
30: terminal disposition region
40: terminal
401: gold layer
402: palladium layer
403: nickel layer
200: packaging substrate
L: singulation line

## Claims

1. A method of manufacturing a packaging substrate, the method comprising:
preparing step of preparing a panel-level packaging substrate comprising a core substrate, a first redistribution layer disposed on the core substrate, and a second redistribution layer disposed under the core substrate; and
electroless surface treatment step of forming terminals by simultaneously performing electroless surface treatment on an upper surface and a lower surface of the panel-level packaging substrate,
wherein the packaging substrate comprises a core layer, the first redistribution layer disposed on the core layer, the second redistribution layer disposed under the core layer, and the terminals disposed on an upper surface of the first redistribution layer and a lower surface of the second redistribution layer, and
wherein a difference between a maximum thickness value and a minimum thickness value of the terminals formed on the packaging substrate is 5 µm or less.

2. The method of claim 1,
further comprising singulating step of singulating the panel-level packaging substrate after completion of the electroless surface treatment step to manufacture two or more packaging substrates,
wherein the packaging substrates respectively have average thickness values (Mt values) of the terminals, and
wherein a difference between a maximum value and a minimum value among the Mt values is 4 µm or less.

3. The method of claim 1,
wherein the terminals comprise a first terminal disposed on the upper surface of the first redistribution layer and a second terminal disposed on the lower surface of the second redistribution layer,
wherein the first terminal comprises a first nickel layer, a first palladium layer disposed on the first nickel layer, and a first gold layer disposed on the first palladium layer, and
wherein the second terminal comprises a second nickel layer, a second palladium layer disposed under the second nickel layer, and a second gold layer disposed under the second palladium layer.

4. The method of claim 3,
wherein the first redistribution layer comprises a first conductive layer in contact with the first terminal, and
wherein an average thickness of the first terminal relative to a thickness of the first conductive layer is in a range of 0.3 to 1.5.

5. The method of claim 3,
wherein a ratio of an average thickness of the first palladium layer to an average thickness of the first nickel layer is in a range of 0.01 to 0.05.

6. The method of claim 3,
wherein a ratio of an average thickness of the first gold layer to an average thickness of the first nickel layer is in a range of 0.01 to 0.05.

7. The method of claim 1,
wherein a thickness of the terminals is in a range of 1 µm to 10 µm.

8. A packaging substrate comprising:
a core layer, a first redistribution layer disposed on the core layer, and a second redistribution layer disposed under the core layer; and
terminals,
wherein the terminals are disposed on an upper surface of the first redistribution layer and a lower surface of the second redistribution layer, and
wherein a difference between a maximum thickness value and a minimum thickness value of the terminals is 5 µm or less.

9. The packaging substrate of claim 8,
wherein the terminals comprise a first terminal disposed on the upper surface of the first redistribution layer and a second terminal disposed on the lower surface of the second redistribution layer,
wherein the first terminal comprises a first nickel layer, a first palladium layer disposed on the first nickel layer, and a first gold layer disposed on the first palladium layer, and
wherein the second terminal comprises a second nickel layer, a second palladium layer disposed under the second nickel layer, and a second gold layer disposed under the second palladium layer.

10. The packaging substrate of claim 9,
wherein the first redistribution layer comprises a first conductive layer in contact with the first terminal, and
wherein an average thickness of the first terminal relative to a thickness of the first conductive layer is in a range of 0.3 to 1.5.

11. The packaging substrate of claim 9,
wherein a ratio of an average thickness of the first palladium layer to an average thickness of the first nickel layer is in a range of 0.01 to 0.05.

12. The packaging substrate of claim 9,
wherein a ratio of an average thickness of the first gold layer to an average thickness of the first nickel layer is in a range of 0.01 to 0.05.

13. The packaging substrate of claim 9,
wherein a thickness of the terminals is in a range of 1 µm to 10 µm.
